# EUROPEAN PATENT APPLICATION

(11) **EP 3 799 135 A1**
(43) Date of publication of application: **31.03.2021**
(21) Application number: 19925027.5
(22) Date of filing: 11.11.2019
(51) Int. Cl.: H01L 31/05, H01L 31/0224

(54) **SOLAR CELL SHEET AND SOLAR CELL ASSEMBLY**

(30) Priority: 19.04.2019 CN 201910319188
(71) Applicant: Longi Solar Technology (Taizhou) Co., Ltd., Taizhou, Jiangsu 225300 (CN)
(72) Inventor: YUAN, Yunlai, Taizhou, Jiangsu 225300 (CN); WANG, Jianbo, Taizhou, Jiangsu 225300 (CN); ZHU, Chen, Taizhou, Jiangsu 225300 (CN); LV, Jun, Taizhou, Jiangsu 225300 (CN)
(74) Representative: Loo, Chi Ching
(86) International application number: PCT/CN2019/117200
(87) International publication number: WO 2020/211343

(57) **Abstract**

A solar-cell piece and a solar-cell assembly, wherein the solar-cell piece includes a plurality of sub-cell-piece units and solder strips, wherein neighboring sub-cell-piece units are superposed, and are connected by the solder strips to form a cell string; and each of the sub-cell-piece units is provided with solder-strip containing slots in positions where the solder strips are located in superposed areas of a front face and a back face, and supporting structures are provided between neighboring solder-strip containing slots. The superposition between the supporting structures at the front face and the back face of the two neighboring sub-cell-piece units can reduce the height difference at the overlapping position, to disperse and release the stress between the neighboring cell pieces generated by the solder strip. Moreover, the supporting structure can strengthen the superposed areas at the front face and the back face of the cell piece, which can improve the toughness of the superposed areas at the front face and the back face of the cell piece, reduce the stress exerted by the solder strip on the sub-cell piece during the laminating of the solar-cell assembly, and reduce the possibility of hidden cracking.

## Description

The present application claims the priority of the Chinese patent application filed on April 19^{th}, 2019 before the Chinese Patent Office with the application number of 20190319188.9 and the title of "SOLAR CELL SHEET AND SOLAR CELL ASSEMBLY", which is incorporated herein in its entirety by reference.

### TECHNICAL FIELD

The present disclosure generally relates to the technical field of solar cells, and particularly relates to a solar-cell piece and a solar-cell assembly.

### BACKGROUND

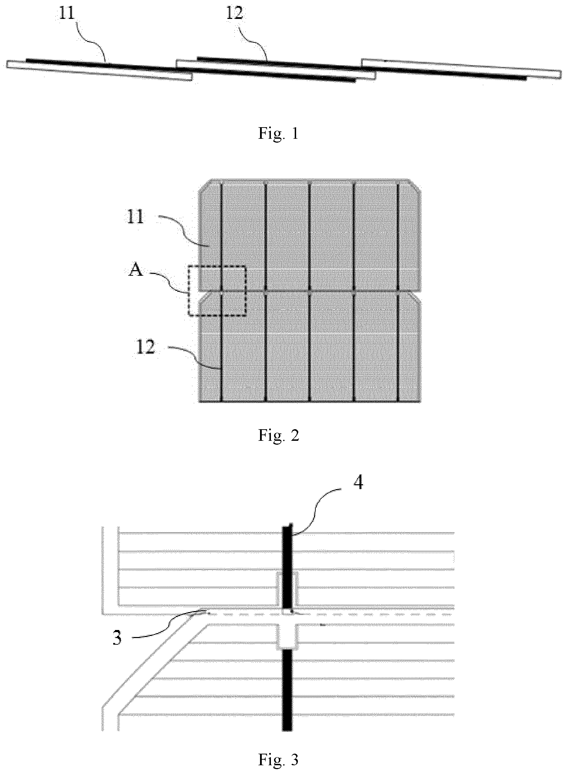

The shingled-assembly technique is a technique in which a solar-cell piece is sliced and then the cell pieces are welded by using a particular dedicated conductive-adhesive material into a string. In recent years, with the mature application of shingled assemblies, a technique in which the small cell pieces are seamlessly spliced by using an ultra-thin solder strip has been increasingly extensively employed. Referring to Fig. 1, such a technique also employs the mode in which the solar-cell piece is cut into sub-cell-piece units 11, which are then laminated and connected, and it differs from the shingled-assembly technique in that the seamless-splicing technique uses an ultra-thin solder strip 12 for the connection between two neighboring sub-cell-piece units 11. The seamless-splicing technique uses the ultra-thin solder strip 12 to replace the expensive conductive-adhesive material, which reduces the cost of the assembly while ensuring the improvement of the conversion efficiency of the assembly, and is considered as a novel assembly solution that can replace the conventional shingled-assembly technique. However, such an interconnecting mode has a severe problem. As shown in Figs. 2 and 3, the solder strip 12 has a certain thickness, and even the ultra-thin solder strip 12 has a thickness of 0.1-0.15mm. The overlapping position between the neighboring sub-cell-piece units 11, because of the solder strip 12, has a height difference from the other positions of the sub-cell-piece units 11 of 0.1-0.15mm. During the laminating of the solar-cell assembly, the sub-cell-piece units 11 undergo the stress from the solder strip 12, which easily generates hidden cracking.

### SUMMARY

In view of the above defects or disadvantages in the prior art, it is desired to provide a solar-cell piece and a solar-cell assembly.

In order to overcome the disadvantages of the prior art, the present application provides the following technical solutions:

In an first aspect, the present application provides a solar-cell piece, wherein the solar-cell piece comprises a plurality of sub-cell-piece units and solder strips, wherein neighboring sub-cell-piece units are superposed, and are connected by the solder strips to form a cell string; and each of the sub-cell-piece units is provided with solder-strip containing slots in positions where the solder strips are located in superposed areas of a front face and a back face, and supporting structures are provided between neighboring solder-strip containing slots.

Optionally, each of the supporting structures at the front faces of the sub-cell-piece units comprises a fine-grid-line row, the fine-grid-line row comprises a plurality of fine grid lines that are closely arranged, a plurality of the fine-grid-line rows are provided in a same straight line, and a distance between ends of neighboring two of the fine-grid-line rows is equal to a width of the solder-strip containing slots.

Optionally, each of the supporting structures at the back faces of the sub-cell-piece units comprises a fine-grid-line row, the fine-grid-line row comprises a plurality of fine grid lines that are closely arranged, a plurality of the fine-grid-line rows are provided in a same straight line, and a distance between ends of neighboring two of the fine-grid-line rows is equal to the width of the solder-strip containing slots.

Optionally, the supporting structures at the back faces of the sub-cell-piece units comprise at least one thick grid line, a plurality of the thick grid lines are provided in a same straight line, and a distance between ends of neighboring two of the thick grid lines is equal to the width of the solder-strip containing slots.

Optionally, a distance between an outmost fine grid line and an edge of the sub-cell-piece unit is 0.2-0.4mm.

Optionally, each of the fine-grid-line rows comprises 6-10 fine grid lines, and a distance between neighboring two of the fine grid lines is 70-100µm.

Optionally, a height of the fine grid lines is 15-20µm.

Optionally, a width of the fine grid lines is 15-20µm.

Optionally, a width of the thick grid lines is 300-350µm.

A solar-cell assembly, wherein the solar-cell assembly comprises the above-described solar-cell piece.

As compared with the prior art, the advantageous effects of the present application are as follows:

The solar-cell piece according to the present application comprises a plurality of sub-cell-piece units and solder strips, wherein neighboring sub-cell-piece units are superposed, and are connected by the solder strips to form a cell string; and each of the sub-cell-piece units is provided with solder-strip containing slots in positions where the solder strips are located in superposed areas of a front face and a back face, and supporting structures are provided between neighboring solder-strip containing slots. The superposition between the supporting structures at the front face and the back face of the two neighboring sub-cell-piece units can reduce the height difference at the overlapping position, to disperse and release the stress between the neighboring cell pieces generated by the solder strip. Moreover, the supporting structure can strengthen the superposed areas at the front face and the back face of the cell piece, which can improve the toughness of the superposed areas at the front face and the back face of the cell piece, reduce the stress exerted by the solder strip on the sub-cell piece during the laminating of the solar-cell assembly, and reduce the possibility of hidden cracking.

The above description is merely a summary of the technical solutions of the present application. In order to more clearly know the elements of the present application to enable the implementation according to the contents of the description, and in order to make one of the above and other purposes, features and advantages of the present application more apparent and understandable, the particular embodiments of the present application are provided below.

### BRIEF DESCRIPTION OF THE DRAWINGS

In order to more clearly illustrate the embodiments of the present application or the technical solutions in the prior art, the figures that are required to describe the embodiments or the prior art will be briefly introduced below. Apparently, the figures that are described below are embodiments of the present application, and a person skilled in the art can obtain other figures according to these figures without paying creative work.

By reading the detailed description on the non-limiting embodiments by referring to the following figures, the other features, one of the objects and the advantages of the present application will become more apparent:
Fig. 1 is a front view of a conventional shingled structure of a solar cell string;
Fig. 2 is a top view of a conventional shingled structure of a solar cell string;
Fig. 3 is a partial enlarged view of the position A in Fig. 2;
Fig. 4 is a front view of the structure of the front face of the sub-cell-piece unit according to an embodiment of the present application;
Fig. 5 is a partial enlarged view of the position B in Fig. 4;
Fig. 6 is a front view of a structure of the back face of the sub-cell-piece unit according to an embodiment of the present application;
Fig. 7 is a partial enlarged view of the position C in Fig. 6;
Fig. 8 is a front view of another structure of the back face of the sub-cell-piece unit according to an embodiment of the present application; and
Fig. 9 is a partial enlarged view of the position D in Fig. 8.

In Figs. 1-2: 11-sub-cell-piece units, and 12-solder strips.

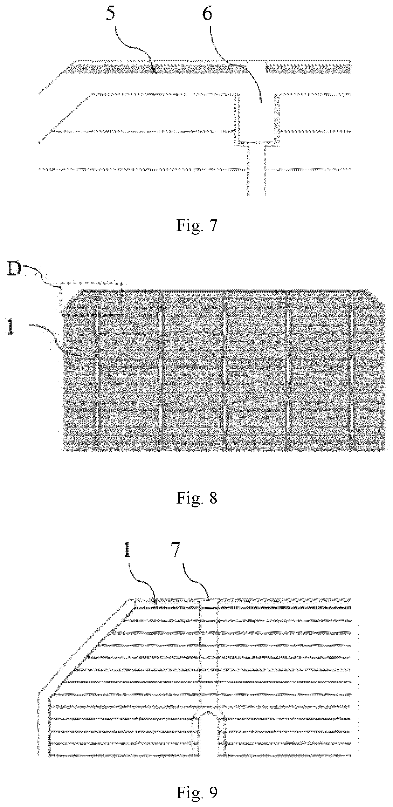

In Figs. 3-9: 1-sub-cell-piece units, 3-superposed areas, 4-solder strips, 5-fine-grid-line row, 6-solder-strip containing slot, and 7-thick grid line.

### DETAILED DESCRIPTION

In order to make one of the objects, the technical solutions and the advantages of the embodiments of the present application clearer, the technical solutions of the embodiments of the present application will be clearly and completely described below with reference to the drawings of the embodiments of the present application. Apparently, the described embodiments are merely certain embodiments of the present application, rather than all of the embodiments. All of the other embodiments that a person skilled in the art obtains on the basis of the embodiments of the present application without paying creative work fall within the protection scope of the present application.

The present application will be described in further detail below with reference to the drawings and the embodiments. It can be understood that the particular embodiments described herein are merely intended to interpret the relevant inventions, and not limit the inventions. It should also be noted that, in order to facilitate the describing, the drawings merely show the parts relative to the inventions.

It should be noted that, subject to the avoiding of any conflict, the embodiments and the features of the embodiments of the present application can be combined. The present application will be described in detail below with reference to the drawings and the embodiments.

As mentioned in the background art, the mode of using an ultra-thin solder strip to connect two neighboring small cell pieces has a severe problem. The solder strip has a certain thickness, and even the ultra-thin solder strip has a thickness of 0.1-0.15mm. The overlapping position between the neighboring solar-cell pieces, because of the solder strip, has a height difference from the other positions of the solar-cell pieces of 0.1-0.15mm. During the laminating of the solar-cell assembly, the solar-cell pieces undergo the stress from the solder strip, which easily generates hidden cracking.

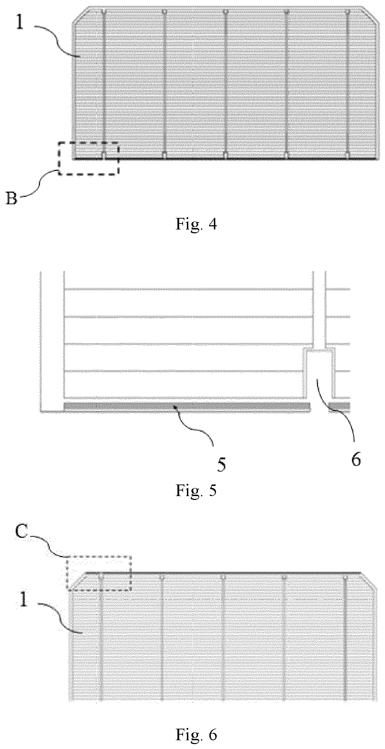

As shown in Figs. 4-9, the present application provides a solar-cell piece, wherein the solar-cell piece comprises a plurality of sub-cell-piece units 1 and solder strips, wherein neighboring sub-cell-piece units 1 are superposed, and are connected by the solder strips 4 to form a cell string. Each of the sub-cell-piece units 1 is provided with solder-strip containing slots 6 in the positions where the solder strips 4 are located in the superposed areas 3 of a front face and a back face, and supporting structures are provided between neighboring solder-strip containing slots 6.

The superposition between the supporting structures at the front face and the back face of the two neighboring sub-cell-piece units 1 can reduce the height difference at the overlapping position, to disperse and release the stress between the neighboring cell pieces generated by the solder strip 4. Moreover, the supporting structure can strengthen the superposed areas 3 at the front face and the back face of the cell piece, which can improve the toughness of the superposed areas 3 at the front face and the back face of the cell piece.

During the laminating between two neighboring sub-cell-piece units 1, the depths of the two solder-strip containing slots 6 plus the heights of the two supporting structures equals to the height difference of the overlapping position. It should be noted that the solder-strip containing slots 6 are blind slots, the depth of the solder-strip containing slots 6 is 5-15µm, and alternatively, the depth of the solder-strip containing slots 6 is 5-10µm.

In an embodiment, each of the supporting structures at the front faces of the sub-cell-piece units 1 comprises a fine-grid-line row 5, and the fine-grid-line row 5 comprises a plurality of fine grid lines that are closely arranged. A plurality of the fine-grid-line rows 5 are provided in the same straight line, and the distance between the ends of neighboring two of the fine-grid-line rows 5 is equal to the width of the solder-strip containing slots 6.

In an embodiment, each of the supporting structures at the back faces of the sub-cell-piece units 1 comprises a fine-grid-line row 5, and the fine-grid-line row 5 comprises a plurality of fine grid lines that are closely arranged. A plurality of the fine-grid-line rows 5 are provided in the same straight line, and the distance between the ends of neighboring two of the fine-grid-line rows 5 is equal to the width of the solder-strip containing slots 6.

In an embodiment, the supporting structures at the back faces of the sub-cell-piece units 1 comprise at least one thick grid line 7, a plurality of the thick grid lines 7 are provided in the same straight line, and the distance between the ends of neighboring two of the thick grid lines 5 is equal to the width of the solder-strip containing slots 6.

In an embodiment, the distance between the outmost fine grid line and the edge of the sub-cell-piece unit 1 is 0.2-0.4mm.

In an embodiment, each of the fine-grid-line rows 5 comprises 6-10 fine grid lines, and the distance between neighboring two of the fine grid lines is 70-100µm.

In an embodiment, the height of the fine grid lines is 15-20µm.

In an embodiment, the width of the fine grid lines is 15-20µm.

In an embodiment, the width of the thick grid lines 7 is 300-350µm. Optionally, the height of the thick grid lines 7 is 15-20µm.

The present application provides a solar-cell piece, wherein the solar-cell assembly comprises the above-described solar-cell piece.

The above contents will be discussed further below by using the particular embodiments.

### The first embodiment

### PERC (Passivated Emitter and Rear Cell) double-side solar-cell piece

A dense fine-grid-line row 5 is provided at the front face of the superposed area 3 of the sub-cell-piece unit 1. The fine-grid-line row 5 comprises 6 fine grid lines. The width of the fine grid lines is 30µm. The height of the fine grid lines is 18µm. The distance between neighboring fine grid lines is 70µm. The distance between the outmost fine grid line and the edge of the cell piece is 0.2mm. A plurality of the fine-grid-line rows 5 are provided in the same straight line, and the distance between the ends of neighboring two of the fine-grid-line rows 5 is equal to the width of the solder-strip containing slots 6. The solder-strip containing slots 6 are used for the laying out of the solder strips 4. The width of the solder-strip containing slots 6 is 0.8mm.

Aluminum thick grid lines 7 are provided at the back face of the superposed area 3 of the sub-cell-piece unit 1. The width of the thick grid lines 7 is controlled to be 330µm. The distance between the thick grid lines 7 and the edge of the sub-cell-piece unit 1 is 0.2mm. A plurality of the thick grid lines 7 are provided in the same straight line, and the distance between the ends of neighboring two of the thick grid lines 5 is equal to the width of the solder-strip containing slots 6. The solder-strip containing slots 6 are used for the laying out of the solder strips 4. The width of the solder-strip containing slots 6 is 0.8mm.

### The second embodiment

### N-type double-side solar-cell piece

A dense fine-grid-line row 5 is provided at the front face of the superposed area 3 of the sub-cell-piece unit 1. The fine-grid-line row 5 comprises 6 fine grid lines. The width of the fine grid lines is 30µm. The height of the fine grid lines is 18µm. The distance between neighboring fine grid lines is 80µm. The distance between the outmost fine grid line and the edge of the sub-cell-piece unit 1 is 0.25mm. A plurality of the fine-grid-line rows 5 are provided in the same straight line, and the distance between the ends of neighboring two of the fine-grid-line rows 5 is equal to the width of the solder-strip containing slots 6. The solder-strip containing slots 6 are used for the laying out of the solder strips 4. The width of the solder-strip containing slots 6 is 0.75mm.

The graphic design of the overlapping position at the back face of the small cell of the N-type double-side cell piece is shown in Fig. 4. The overlapping area at the back face of the sub-cell-piece unit is provided with a dense fine-grid-line row 5. The fine-grid-line row 5 may be controlled to comprise 6 fine grid lines. The width of the grid lines is controlled to be 30µm. The height of the grid lines may be controlled to be 20µm. The distance between the grid lines is controlled to be 80µm. The distance between the outmost grid line and the edge of the cell piece is controlled to be 0.25mm. A plurality of the fine-grid-line rows 5 are provided in the same straight line, and the distance between the ends of neighboring two of the fine-grid-line rows 5 is equal to the width of the solder-strip containing slots 6. The solder-strip containing slots 6 are used for the laying out of the solder strips 4. The width of the solder-strip containing slots 6 is 0.75mm.

The above description is merely description on the preferable embodiments of the present application and the technical principles that are utilized. A person skilled in the art should understand that the scope that is involved in the present application is not limited to the technical solutions that are obtained from the particular combinations of the above technical features, but should also encompass the technical solutions that are formed by the random combinations between the above technical features and their equivalent features without departing from the inventive concept, for example, the technical solutions that are formed by the mutual substitution between the above features and the technical features having the similar functions to those disclosed by (not limited to) the present application.

The above-described device embodiments are merely illustrative, wherein the units that are described as separate components may or may not be physically separate, and the components that are displayed as units may or may not be physical units; in other words, they may be located at the same one location, and may also be distributed to a plurality of network units. Part or all of the modules may be selected according to the actual demands to realize one of the purposes of the solutions of the embodiments. A person skilled in the art can understand and implement the technical solutions without paying creative work.

The "one embodiment", "an embodiment" or "one or more embodiments" as used herein means that particular features, structures or characteristics described with reference to an embodiment are included in at least one embodiment of the present application. Moreover, it should be noted that here an example using the wording "in an embodiment" does not necessarily refer to the same one embodiment.

The description provided herein describes many concrete details. However, it can be understood that the embodiments of the present application may be implemented without those concrete details. In some of the embodiments, well-known processes, structures and techniques are not described in detail, so as not to affect the understanding of the description.

Finally, it should be noted that the above embodiments are merely intended to explain the technical solutions of the present application, and not to limit them. Although the present application is explained in detail by referring to the above embodiments, a person skilled in the art should understand that he can still modify the technical solutions set forth by the above embodiments, or make equivalent substitutions to part of the technical features of them. However, those modifications or substitutions do not make the essence of the corresponding technical solutions depart from the spirit and scope of the technical solutions of the embodiments of the present application.

## Claims

1. A solar-cell piece, wherein the solar-cell piece comprises a plurality of sub-cell-piece units and solder strips, wherein neighboring sub-cell-piece units are superposed, and are connected by the solder strips to form a cell string; and
each of the sub-cell-piece units is provided with solder-strip containing slots in positions where the solder strips are located in superposed areas of a front face and a back face, and supporting structures are provided between neighboring solder-strip containing slots.

2. The solar-cell piece according to claim 1, wherein each of the supporting structures at the front faces of the sub-cell-piece units comprises a fine-grid-line row, the fine-grid-line row comprises a plurality of fine grid lines that are closely arranged, a plurality of the fine-grid-line rows are provided in a same straight line, and a distance between ends of neighboring two of the fine-grid-line rows is equal to a width of the solder-strip containing slots.

3. The solar-cell piece according to claim 2, wherein each of the supporting structures at the back faces of the sub-cell-piece units comprises a fine-grid-line row, the fine-grid-line row comprises a plurality of fine grid lines that are closely arranged, a plurality of the fine-grid-line rows are provided in a same straight line, and a distance between ends of neighboring two of the fine-grid-line rows is equal to the width of the solder-strip containing slots.

4. The solar-cell piece according to claim 2, wherein the supporting structures at the back faces of the sub-cell-piece units comprise at least one thick grid line, a plurality of the thick grid lines are provided in a same straight line, and a distance between ends of neighboring two of the thick grid lines is equal to the width of the solder-strip containing slots.

5. The solar-cell piece according to any one of claims 2 to 4, wherein a distance between an outmost fine grid line and an edge of the sub-cell-piece unit is 0.2-0.4mm.

6. The solar-cell piece according to claim 5, wherein each of the fine-grid-line rows comprises 6-10 fine grid lines, and a distance between neighboring two of the fine grid lines is 70-100µm.

7. The solar-cell piece according to claim 6, wherein a height of the fine grid lines is 15-20µm.

8. The solar-cell piece according to claim 7, wherein a width of the fine grid lines is 15-20µm.

9. The solar-cell piece according to claim 4, wherein a width of the thick grid lines is 300-350µm.

10. A solar-cell assembly, wherein the solar-cell assembly comprises the solar-cell piece according to any one of claims 1-9.
